Europäisches Patentamt

European Patent Office

Office européen des brevets

(11) Veröffentlichungsnummer: **0 265 937 B1**

(12) **EUROPÄISCHE PATENTSCHRIFT**

(45) Veröffentlichungstag der Patentschrift: **08.05.91**

(51) Int. Cl.⁵: **C23C 14/06,** F16C 33/12, C23C 14/02

(21) Anmeldenummer: **87115861.4**

(22) Anmeldetag: **29.10.87**

(54) Gleitlagerung.

(30) Priorität: 30.10.86 DE 3636914
28.11.86 DE 3640767

(43) Veröffentlichungstag der Anmeldung:
04.05.88 Patentblatt 88/18

(45) Bekanntmachung des Hinweises auf die
Patenterteilung:
08.05.91 Patentblatt 91/19

(84) Benannte Vertragsstaaten:
AT CH DE ES FR GB IT LI SE

(56) Entgegenhaltungen:
EP-A- 0 256 226      DE-A- 2 853 724
DE-A- 2 914 618      DE-A- 3 621 184
FR-A- 2 559 507      US-A- 4 471 032

(73) Patentinhaber: KOLBENSCHMIDT Aktiengesellschaft
Karl-Schmidt-Strasse 8/12 Postfach 1351
W-7107 Neckarsulm(DE)

(72) Erfinder: Bergmann, Erich, Dr.
Sarganser Strasse 58
CH-8887 Mels(CH)
Erfinder: Braus, Jürgen
Johann-Jakob-Ast-Strasse 53
W-6909 Walldorf(DE)
Erfinder: Matucha, Karl-Heinz, Dr.
Achimweg 2
W-6233 Kelkheim(DE)
Erfinder: Pfestorf, Harald
Panoramastrasse 18/1
W-7101 Untereisesheim(DE)
Erfinder: Wincierz, Peter, Prof. Dr.
Hohenwaldstrasse 29
W-6374 Steinbach(DE)

(74) Vertreter: Rieger, Harald, Dr.
Reuterweg 14
W-6000 Frankfurt am Main(DE)

EP 0 265 937 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine Gleitlagerung aus wenigstens einer durch Kathodenzerstäubung auf eine metallische Unterstützung oder Führung aufgetragene metallische Gleitschicht, bei der in einer metallischen Matrix Partikel eines metallischen Gleitwerkstoffs und Sauerstoff eingelagert sind.

Als Folge der Entwicklung im Brennkraftmaschinenbau zu möglichst hoher Leistungsdichte bei möglichst guter Wirtschaftlichkeit in Form niedriger Kraftstoffverbräuche und günstiger Herstellkosten sind u.a. auch die Anforderungen an die Gleitlagerungen des Triebwerks, insbesondere im Hinblick auf höhere Festigkeiten gegenüber dynamischen Wechselbeanspruchungen im Gebiet der Flüssigkeitsreibung sowie an das Gleitverhalten im Gebiet der Mischreibung, gestiegen. Für den Hersteller besteht somit die Aufgabe, Gleitlagerungen zu entwickeln, die den Belastungen in der modernen Brennkraftmaschinentechnik, d.h. den gesteigerten Zünddrücken, der höheren Verdichtung und den Aufladungen, weitgehend angepaßt sind.

Zur Lösung dieses Detailproblems ist in der DE-PS 28 53 724 ein Werkstoffverbund vorgesehen, bei dem auf eine Trägerschicht durch Kathodenzerstäubung eine metallische Gleit- bzw. Reibschicht aufgebracht ist, in der härtere dispersionsverfestigend wirkende Teilchen in wesentlich unter 1 Gew.% liegender Menge eingelagert sind, wobei die härteren Teilchen aus Oxiden von in dem Metall enthaltenen Bestandteilen bestehen und aus Oxiden solcher Metalle gebildet sind, bei denen das Metalloxid ein größeres Volumen als das Metall selbst aufweist. Das Ziel der Dispersionsverfestigung ist, die Beweglichkeit von Gitterbaufehlern, z.B. Versetzungen und Korngrenzen, durch die in feindisperser Verteilung vorliegenden Oxide so zu behindern, daß auch bei erhöhter Temperatur die Festigkeit und die Warmverschleißfestigkeit erhöht werden. Die für die Bildung der Oxide erforderliche Sauerstoffmenge ist entweder bereits in den durch normalen Strangguß hergestellten Targets enthalten oder wird während der Kathodenzerstäubung in das Plasmagas eingeleitet. In ähnlicher Weise ist in der DE-PS 29 14 618 vorgeschlagen, in die Matrix einer aus Aluminium bestehenden Gleitschicht Oxidteilchen in einer Konzentration von 0,1 bis 0,5 Vol.% einzulagern.

Aus der älteren EP-A-0 256 226 ist ein Verbundwerkstoff mit mindestens einer durch Kathodenzerstäubung aufgebrachten Gleitschicht bekannt, die aus einem Gemisch von in statistischer Verteilung aufgestäubten Teilchen aus mindestens einem eine fest zusammengefügte Matrix bildenden metallischen Werkstoff und mindestens einem weiteren metallischen Werkstoff, der in festem Zustand praktisch nicht im Werkstoff der Matrix löslich ist, besteht. Dabei weist der in der Matrix unlösliche Werkstoff einen niedrigeren Schmelzpunkt als der Matrixwerkstoff und der Durchmesser der Partikel aus dem in der Matrix unlöslichen Werkstoff eine statistische Normalverteilung mit einem Mittelwert von $\bar{x} < 0,8\ \mu m$ auf.

Da mit zunehmenden Mengenanteilen dispersionshärtender Oxide die Duktilität der Gleit- bzw. Reibschicht abnimmt und insbesondere das Notlauf- und Einlaufverhalten verschlechtert werden, kann das an sich erwünschte Potential der Dispersionshärtung zur Erzielung einer hohen Warmfestigkeit für Gleitlagerungen nicht ausgeschöpft werden.

Der Erfindung liegt dementsprechend die Aufgabe zugrunde, Gleitlagerungen des eingangs beschriebenen Aufbaus dahingehend zu verbessern, daß eine höhere Festigkeit gegenüber dynamischen Wechselbeanspruchungen im Gebiet der Flüssigkeitsreibung in Kombination mit einem guten Gleitverhalten im Gebiet der Mischreibung einstellbar sind.

Diese Aufgabe wird erfindungsgemäß dadurch gelöst, daß die einen Durchmesser mit einem Mittelwert von $\bar{x} < 0,8\ \mu m$ aufweisenden, in statistischer Verteilung in der Matrix eingelagerten Partikel aus einem Gleitwerkstoff bestehen, der bessere Gleiteigenschaften als die Matrix besitzt und der Sauerstoffgehalt 0,5 bis 2,0 Gew.% mit der Maßgabe beträgt, daß mit abnehmendem Durchmesser der Partikel der Sauerstoffgehalt ansteigt. Bei einer derartig aufgebauten Gleitschicht weisen gegenüber dem vorstehend beschriebenen Stand der Technik die in der Matrix eingelagerten Partikel eine rund 10mal feinere Verteilung auf, wodurch eine nach DIN 50 133 geprüfte Ausgangshärte der Gleitschicht von 100 bis 130 HV 0,002 erzielt wird. Diese Härte sinkt nach einer 250 h dauernden Warmauslagerung bei 170°C um weniger als 25 %, also auf Härtewerte von > 75 bis > 97,5 HV 0,002 ab, während die nach DIN 50 133 gemessene Ausgangshärte und Endhärte der Gleitschicht des nach DE-PS 28 53 724 aufgebauten Schichtwerkstoffs nach der gleichen Warmauslagerung mit ca. 60 HV 0,002 zwar gleich bleibt, aber vergleichsweise deutlich niedriger ist.

Durch den erfindungsgemäß hohen Sauerstoffgehalt der Matrix wird eine weitgehende Einhüllung der feinverteilten metallischen Partikel durch Sauerstoff erzielt und dadurch die Gefahr reduziert, daß die Partikel bei Betriebstemperatur deutlich wachsen und bedingt dadurch die vorteilhaften Eigenschaften der erfindungsgemäß aufgebauten Gleitschichten teilweise wieder verlorengehen. Die Verhältnisse im Zeitpunkt der Erzeugung der Gleitschicht werden durch den vergleichsweise hohen Sauerstoffgehalt so stabilisiert, daß die Härte der Gleitschicht nach der Warmauslagerung auf Werte abfällt, die über den Härtewerten für bekannte Gleitschichten liegen. Auf diesem Effekt beruht die wesentlich gesteigerte Festigkeit der erfin-

EP 0 265 937 B1

dungsgemäßen Gleitschicht gegenüber dynamischer Wechselbeanspruchung im Gebiet der Flüssigkeitsreibung sowie die gesteigerte Verschleißfestigkeit im Gebiet der Mischreibung.

Im Rahmen der Ausgestaltung der Erfindung besitzen die in statistischer Normalverteilung in der Matrix eingelagerten Partikel einen Durchmesser mit einem Mittelwert $\bar{x} = 0,05$ bis $0,4$ $\mu$m, wobei die Experimente ergeben haben, daß mit einem erfindungsgemäßen Effekt noch bis etwa zu einem Wert von $\bar{x} < 0,8$ $\mu$m gerechnet werden kann.

Zweckmäßigerweise ist die Matrix aus einem Gleitwerkstoff auf Aluminium-, Kupfer- oder Eisenbasis gebildet, wobei die in die Matrix eingelagerten Partikel aus Zinn, Blei, Wismut, Kupfer und Zink bestehen und einzeln oder zu mehreren in der Matrix eingelagert sind.

In der Praxis hat es sich als besonders vorteilhaft erwiesen, wenn die Gleitschicht insgesamt eine Legierungszusammensetzung der folgenden Kombinationen AlSn5Cu, AlSn10Cu, AlSn20Cu, AlSn30Cu, AlSn40Cu, AlSn10Pb10Cu und AlZn5Pb besitzt. Gegebenenfalls kann auch noch Silizium in der Matrix eingelagert sein.

Die Gleitschichten besitzen zweckmäßig eine Schichtdicke von 5 bis 500 $\mu$m, wobei für die meisten Anwendungsfälle die Schichtdicke von 10 bis 20 $\mu$m geeignet ist.

Es besteht die Möglichkeit, mehrere Gleitschichten laminatartig übereinander anzuordnen, wobei sich eine Schichtdicke für die laminatartig aufgebaute Gleitschicht von 50 bis 500 $\mu$m, vorzugsweise 50 bis 150 $\mu$m als zweckmäßig erwiesen hat.

Die einzelnen laminatartig übereinander angeordneten Gleitschichten können unterschiedlich dick sein, erfindungsgemäß aus unterschiedlichen Gleitwerkstoffen bestehen und ggf. unterschiedlichen Sauerstoffgehalt und/oder Partikeldurchmesser besitzen, wobei die Zusammensetzung der einzelnen Gleitschicht gleitend in die jeweils benachbarten Gleitschichten übergehen.

Nach einem vorzugsweisen Merkmal ist zwischen der Gleitschicht und der Unterstützung oder Führung eine Zwischenschicht aus Nickel, Aluminium oder deren Legierungen, vorzugsweise aus NiCu, durch Kathodenzerstäubung aufgebracht, die die Haftfestigkeit der Gleitschicht verbessert und/oder als Diffusionssperrschicht dient. Die Dicke dieser Zwischenschicht beträgt zweckmäßig 1 bis 5 $\mu$m, vorzugsweise 1,5 bis 2,5 $\mu$m. Es hat sich als vorteilhaft erwiesen, wenn die Zusammensetzung der Gleitschicht und der Zwischenschicht kontinuierlich ineinander übergehen.

Die vorzugsweise Ausbildung der Gleitlagerung besteht darin, daß die metallische Gleitschicht auf einer Stützschicht aus Stahl aufgetragen ist.

Die tragende Unterstützung oder Führung kann auch aus einem aus einer Stahlschicht und einer darauf befindlichen Trägerschicht aus einer Kupfer-, Aluminium- oder Eisenlegierung gebildeten Werkstoffverbund bestehen.

Beim Verfahren zum Herstellen der erfindungsgemäßen Gleitlagerung, bei dem die metallische Gleitschicht, bestehend aus in der metallischen Matrix eingelagerten Partikeln eines metallischen Gleitwerkstoffs und Sauerstoff, durch Kathodenzerstäubung erzeugt wird, ist es erforderlich, daß die Temperatur der zu beschichtenden Unterstützung oder Führung während des Auftragens der Gleitschicht durch Kathodenzerstäubung bei einer Temperatur gehalten wird, die wesentlich $< 0,5$ $T_s$ ($T_s$ = absolute Schmelztemperatur des Matrixbasismetalls) ist. Wie sich überraschenderweise herausgestellt hat, führt eine derartig niedrige Temperatur zu einer unerwarteten Verminderung des mittleren Durchmessers der in der Matrix eingelagerten Partikel auf Werte zwischen 0,05 und 0,8 $\mu$m, wobei die Partikel in der Matrix um so feiner und gleichmäßiger verteilt sind, je tiefer die Temperatur der Unterstützung bzw. Führung ist. Als tiefste in Betracht kommende Temperatur ist Raumtemperatur anzunehmen.

Neben der vergleichsweise niedrigen Temperatur der Unterstützung bzw. Führung trägt nach einem weiteren Erfindungsmerkmal die Beschichtungsgeschwindigkeit von größer 0,2 $\mu$m/min bei der Kathodenzerstäubung zur Ausbildung der Feinkörnigkeit der Gleitschicht bei.

Der in die Gleitschicht einzubringende Sauerstoff kann gasförmig als elementarer Sauerstoff, Luft oder als Sauerstoffverbindung eines oder mehrerer der Elemente Wasserstoff, Kohlenstoff und Stickstoff während der Kathodenzerstäubung dem Plasmagas zugeführt werden. Von diesen Sauerstoffverbindungen haben sich Wasserdampf und Kohlendioxid als besonders geeignet erwiesen.

Üblicherweise wird als Plasmagas vorzugsweise Argon verwendet und während des Auftragens der Gleitschicht durch Kathodenzerstäubung im Vakuum ein Partialdruck des den Sauerstoff liefernden Gases von 1 bis 50 % des Gesamtdrucks aufrecht erhalten.

Andererseits besteht die Möglichkeit, die erforderliche Sauerstoffmenge als Oxid in das bei der Kathodenzerstäubung verwendete, die Werkstoffe für die Matrix und die darin einzulagernden Partikel enthaltende Target, einzubinden. Daduch entsteht die Möglichkeit, die Menge des Sauerstoffs in der Gleitschicht über den Oxidgehalt des Targets oder über die elektrische Leistungsdichte des Targets während der Kathodenzerstäubung zu steuern.

3

Eine Ausgestaltung des Verfahrens besteht darin, daß die die Gleitschicht bildenden Komponenten gleichzeitig auf die Unterstützung bzw. Führung aufgetragen werden, wodurch die Feinverteilung der Partikel zusätzlich verbessert wird. Dies kann dadurch erreicht werden, daß wenigstens 50 % des eingesetzten Targets sowohl den die Matrix bildenden als auch den in der Matrix als Partikel einzulagernden Gleitwerkstoff enthält.

Es besteht auch die Möglichkeit, die die Gleitschicht bildenden Komponenten zeitlich nacheinander auf die Unterstützung bzw. Führung aufzutragen. Dazu werden vorteilhafterweise Targets aus dem die Matrix der Gleitschicht bildenden Gleitwerkstoff eingesetzt und an verschiedenen Positionen aufgetragen.

Besonders vorteilhaft kann es sein, für die Erzeugung der zwischen der Gleitschicht und der Unterstützung bzw. Führung angeordneten Zwischenschicht die gleichen Targets wie für die Gleitschicht einzusetzen und die Zwischenschicht und Gleitschicht unmittelbar nacheinander aufzubringen.

In einer weiteren Verfahrensvariante wird die Temperatur der Unterstützung bzw. Führung in dem Sinne variiert, daß die Matrix bei einer hoheren Temperatur als die in der Matrix eingelagerten Partikel aufgebracht wird. Dies kann in einer weiteren Verfahrensvariante derart geschehen, daß der die Matrix bildende Gleitwerkstoff bei einer hoheren Temperatur der Unterstützung bzw. Führung zeitlich vor dem darin als Partikel eingelagerten Gleitwerkstoff aufgebracht wird und die Temperatur während des Beschichtungsvorgangs abgesenkt wird.

Die erfindungsgemäße Gleitlagerung kann sowohl für Gleitlagertypen als auch Gleitlager-Bauteile gemäß DIN ISO 4378 erfolgreich eingesetzt werden.

Die mit der Erfindung erzielten Vorteile werden anhand von Ausführungsbeispielen näher erläutert.

Auf die aus herkömmlichem Werkzeugstahl vom Typ C80W2 bestehenden Lagerhalbschalen A,B,C,D,E und F war jeweils eine aus der Aluminiumlegierung vom Typ AlSn20Cu gebildete 15 $\mu$m dicke Gleitschicht bei einer Beschichtungsgeschwindigkeit von 0,3 $\mu$m/min und einer Temperatur von 60°C der Lagerhalbschalen abgeschiedenen worden, wobei die Gleitschicht der Lagerhalbschalen A,B und C nahezu sauerstoffrei war und diejenige der Lagerhalbschalen D,E und F durchschnittlich 1,12 Gew.% Sauerstoff enthielt.

In der nachfolgenden Tabelle sind die Meßergebnisse der Prüfung der Ausgangshärte und der Endhärte der Gleitschichten (Mittelwerte aus je sechs Einzelmessungen) nach einer Warmauslagerung bei 170°C und 250 h gemäß DIN 50 133 für eine Vickershärte HV 0,002 wiedergegeben.

| Lagerschale | Sauerstoff- gehalt (%) | Ausgangshärte $H_0$ HV 0,002 | Endhärte H/Aus- gangshärte $H_0$ |
|---|---|---|---|
| A | nahezu sauerstoffrei | 112 | 0,59 |
| B | nahezu sauerstoffrei | 109 | 0,66 |
| C | nahezu sauerstoffrei | 109 | 0,66 |
| D | 1,80 | 112 | 0,87 |
| E | 1,05 | 102 | 0,82 |
| F | 0,5 | 103 | 0,83 |

Eine vergleichende Gegenüberstellung der Meßergebnisse zeigt, daß bei einer größenordnungsmäßig etwa gleichen Ausgangshärte $H_0$ der Härteabfall, dargestellt als Quotient von Endhärte H/Ausgangshärte $H_0$, der Gleitschicht bei den Lagerhalbschalen A,B und C kleiner als bei den Lagerhalbschalen D,E und F ist. Hieraus kann geschlossen werden, daß für Gleitlagerungen mit einer durch Kathodenzerstäubung auf einer metallischen Unterstützung erzeugten Gleitschicht ein über 0,5 Gew.% liegender Sauerstoffgehalt erforderlich ist, um eine verbesserte Anlaßbeständigkeit der Härte zu erzielen.

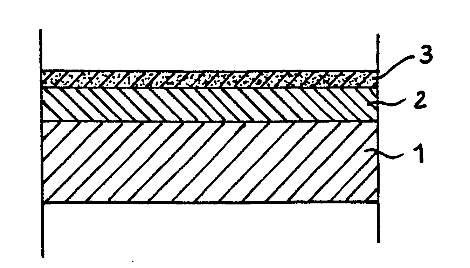

In der Zeichnung ist ein Querschnitt durch eine erfindungsgemäß gestaltete Gleitlagerung schematisch und beispielhaft dargestellt. Auf einer Stahlschicht (1) befindet sich eine aus Bleizinnbronze bestehende 300 $\mu$m dicke Trägerschicht (2), auf die eine Gleitschicht (3) aus AlSn20Cu mit einer Schichtdicke von 50 $\mu$m durch Kathodenzerstäubung aufgetragen ist.

**Ansprüche**

1. Gleitlagerung aus wenigstens einer durch Kathodenzerstäubung auf eine metallische Unterstützung oder Führung aufgetragene metallische Gleitschicht, bei der in einer metallischen Matrix Partikel eines metallischen Gleitwerkstoffs und Sauerstoff eingelagert sind, dadurch gekennzeichnet, daß die einen Durchmesser mit einem Mittelwert von $\bar{x} < 0,8$ $\mu$m aufweisenden, in statistischer Verteilung eingelagerten Partikel aus einem Gleitwerkstoff bestehen, der bessere Gleiteigenschaften als die Matrix besitzt und der Sauerstoffgehalt 0,5 bis 2,0 Gew.% mit der Maßgabe beträgt, daß mit abnehmendem Durchmesser der Partikel der Sauerstoffgehalt ansteigt.

2. Gleitlagerung nach Anspruch 1, dadurch gekennzeichnet, daß der Durchmesser der in statistischer Normalverteilung vorliegenden Partikel einen Mittelwert von $\bar{x} = 0,05$ bis 0,4 $\mu$m besitzt.

3. Gleitlagerung nach den Ansprüchen 1 und 2, dadurch gekennzeichnet, daß die Matrix aus einem Gleitwerkstoff auf Aluminium-, Kupfer- oder Eisenbasis besteht.

4. Gleitlagerung nach den Ansprüchen 1 und 3, dadurch gekennzeichnet, daß die Partikel aus Zinn, Blei, Wismut Kupfer und Zink bestehen und einzeln oder zu mehreren in der Matrix eingelagert sind.

5. Gleitlagerung nach den Ansprüchen 1 bis 4, dadurch gekennzeichnet, daß die metallische Gleitschicht aus einer Legierung des Typs AlSn5Cu, AlSn10Cu, AlSn20Cu, AlSn30Cu, AlSn40Cu, AlSn10Pb10Cu oder AlZn5Pb besteht.

6. Gleitlagerung nach den Ansprüchen 1 bis 5, dadurch gekennzeichnet, daß die Gleitschicht 5 bis 500 $\mu$m, vorzugsweise 10 bis 20 $\mu$m dick ist.

7. Gleitlagerung nach den Ansprüchen 1 bis 6, dadurch gekennzeichnet, daß mehrere Gleitschichten laminatartig übereinander angeordnet sind.

8. Gleitlagerung nach Anspruch 7, dadurch gekennzeichnet, daß die laminatartig aufgebaute Gleitschicht 50 bis 500 $\mu$m, vorzugsweise 50 bis 150 $\mu$m dick ist.

9. Gleitlagerung nach den Ansprüchen 7 und 8, dadurch gekennzeichnet, daß die einzelnen laminatartig übereinander angeordneten Gleitschichten unterschiedlich dick sind.

10. Gleitlagerung nach den Ansprüchen 7 bis 9, dadurch gekennzeichnet, daß die einzelnen laminatartig übereinander angeordneten Gleitschichten aus unterschiedlichen Gleitwerkstoffen bestehen und ggf. unterschiedlichen Sauerstoffgehalt und/oder Partikeldurchmesser besitzen.

11. Gleitlagerung nach Anspruch 10, dadurch gekennzeichnet, daß die Zusammensetzung der einzelnen laminarartig übereinander angeordneten Gleitschichten kontinuierlich in die Zusammensetzung der jeweils benachbarten Gleitschichten übergeht.

12. Gleitlagerung nach den Ansprüchen 1 bis 11, dadurch gekennzeichnet, daß zwischen der Gleitschicht und der Unterstützung oder Führung eine Zwischenschicht aus Nickel, Aluminium oder deren Legierungen, vorzugsweise aus NiCu, angebracht ist.

13. Gleitlagerung nach Anspruch 12, dadurch gekennzeichnet, daß die Zwischenschicht 1 bis 5 $\mu$m, vorzugsweise 1,5 bis 2,5 $\mu$m dick ist.

14. Gleitlagerung nach den Ansprüchen 12 und 13, dadurch gekennzeichnet, daß die Zusammensetzung der Gleitschicht und der Zwischenschicht kontinuierlich ineinander übergehen.

15. Gleitlagerung nach einem oder mehreren der Ansprüche 1 bis 14, dadurch gekennzeichnet, daß die die Gleitschicht tragende Unterstützung oder Führung aus einer Stahlschicht besteht.

16. Gleitlagerung nach einem oder mehreren der Ansprüche 1 bis 14, dadurch gekennzeichnet, daß die die Gleitschicht tragende Unterstützung oder Führung aus einem aus einer Stahlschicht mit einer darauf befindlichen Trägerschicht aus einer Kupfer-, Aluminium- oder Eisenlegierung gebildeten Werkstoffverbund besteht.

17. Verfahren zur Herstellung der Gleitlagerung nach den Ansprüchen 1 bis 16 durch Auftragen einer

EP 0 265 937 B1

metallischen Gleitschicht, bei der in einer metallischen Matrix Partikel eines metallischen Gleitwerkstoffs und Sauerstoff eingelagert sind, auf eine metallische Unterstützung oder Führung mittels Kathodenzerstäubung, dadurch gekennzeichnet, daß die Unterstützung bzw. Führung während der Kathodenzerstäubung bei einer Temperatur gehalten wird, die wesentlich kleiner als 0,5 $T_s$ ist, wobei $T_S$ die absolute Schmelztemperatur des Matrixbasismetalls bedeutet.

**18.** Verfahren nach Anspruch 17, dadurch gekennzeichnet, daß die Beschichtungsgeschwindigkeit größer 0,2 $\mu$m/min beträgt.

**19.** Verfahren nach den Ansprüchen 17 und 18, dadurch gekennzeichnet, daß der in die Gleitschicht einzulagernde Sauerstoff dem Plasmagas gasförmig als elementarer Sauerstoff, Luft oder als Sauerstoffverbindung eines oder mehrerer der Elemente Wasserstoff, Kohlenstoff und Stickstoff zugeführt wird.

**20.** Verfahren nach den Ansprüchen 17 bis 19, dadurch gekennzeichnet, daß als Plasmagas Argon eingesetzt und während der Kathodenzerstäubung im Vakuum ein Partialdruck des den Sauerstoff liefernden Gases von 1 bis 50 % des Gesamtdrucks aufrecht erhalten wird.

**21.** Verfahren nach den Ansprüchen 17 und 18, dadurch gekennzeichnet, daß der in die Gleitschicht einzulagernde Sauerstoff als Oxid in das bei der Kathodenzerstäubung verwendete, die Matrix und die Partikel enthaltende Target eingelagert ist.

**22.** Verfahren nach den Ansprüchen 17 bis 21, dadurch gekennzeichnet, daß die die Gleitschicht bildenden Komponenten gleichzeitig auf die Unterstützung bzw. Führung aufgebracht werden.

**23.** Verfahren nach Anspruch 22, dadurch gekennzeichnet, daß wenigstens 50 % des verwendeten Targets aus den die Gleitschicht bildenden Komponenten bestehen.

**24.** Verfahren nach den Ansprüchen 17 bis 21, dadurch gekennzeichnet, daß die die Gleitschicht bildenden Komponenten zeitlich nacheinander auf die Unterstützung bzw. Führung aufgebracht werden.

**25.** Verfahren nach den Ansprüchen 17 bis 24, dadurch gekennzeichnet, daß die zwischen der Gleitschicht und der Unterstützung bzw. Führung angeordnete Zwischenschicht unter Verwendung der gleichen Targets wie für die Gleitschicht aufgebracht wird.

**26.** Verfahren nach den Ansprüchen 17 bis 25, dadurch gekennzeichnet, daß die Matrix bei einer höheren Temperatur als die in der Matrix eingelagerten Partikel auf die Unterstützung bzw. Führung aufgetragen wird.

**27.** Anwendung der Gleitlagerung nach den Ansprüchen 1 bis 16 für Gleitlagertypen und Gleitlager-Bauteile gemäß DIN ISO 4378.

## Claims

**1.** Sliding bearing consisting of at least one metallic sliding layer applied to a metallic backing or guide by cathode sputtering, in which particles of a metallic sliding material and oxygen are incorporated in a metallic matrix, characterised in that the particles which have a diameter with an average value of $\bar{x} < 0.8$ $\mu$m and which are incorporated in a random distribution consist of a sliding material which has better sliding properties than the matrix, and the oxygen content is 0.5 to 2.0% by weight, with the proviso that the oxygen content increases with decreasing diameter of the particles.

**2.** Sliding bearing according to Claim 1, characterised in that the diameter of the particles which are present in a normal random distribution has an average value of $\bar{x} = 0.05$ to 0.4 $\mu$m.

**3.** Sliding bearing according to Claims 1 and 2, characterised in that the matrix consists of a sliding material on an aluminium, copper or iron basis.

4. Sliding bearing according to Claims 1 and 3, characterised in that the particles consist of tin, lead, bismuth, copper and zinc and are incorporated in the matrix individually or in combination.

5. Sliding bearing according to Claims 1 to 4, characterised in that the metallic sliding layer consists of an alloy of the type AlSn5Cu, AlSn10Cu, AlSn20Cu, AlSn30Cu, AlSn40Cu, AlSn10Pb10Cu or AlZn5Pb.

6. Sliding bearing according to Claims 1 to 5, characterised in that the sliding layer is 5 to 500 $\mu$m, preferably 10 to 20 $\mu$m, thick.

7. Sliding bearing according to Claims 1 to 6, characterised in that a plurality of sliding layers are arranged in laminate fashion one over the other.

8. Sliding bearing according to Claim 7, characterised in that the sliding layer constructed in laminate fashion is 50 to 500 $\mu$m, preferably 50 to 150 $\mu$m, thick.

9. Sliding bearing according to Claims 7 and 8, characterised in that the individual sliding layers arranged one over the other in laminate fashion are of different thicknesses.

10. Sliding bearing according to Claims 7 to 9, characterised in that the individual sliding layers arranged one over the other in laminate fashion consist of different sliding materials and optionally have different oxygen contents and/or particle diameters.

11. Sliding bearing according to Claim 10, characterised in that the composition of the individual sliding layers arranged one over the other in laminate fashion merges continuously into the composition of the respective adjacent sliding layers.

12. Sliding bearing according to Claims 1 to 11, characterised in that an intermediate layer of nickel, aluminium or alloys thereof, preferably of NiCu, is provided between the sliding layer and the backing or guide.

13. Sliding bearing according to Claim 12, characterised in that the intermediate layer is 1 to 5 $\mu$m, preferably 1.5 to 2.5 $\mu$m, thick.

14. Sliding bearing according to Claims 12 and 13, characterised in that the compositions of the sliding layer and the intermediate layer merge continuously into each other.

15. Sliding bearing according to one or more of Claims 1 to 14, characterised in that the backing or guide bearing the sliding layer consists of a steel layer.

16. Sliding bearing according to one or more of Claims 1 to 14, characterised in that the backing or guide bearing the sliding layer consists of a composite formed of a steel layer with a carrier layer of a copper, aluminium or iron alloy located thereon.

17. Process for manufacturing the sliding bearing according to Claims 1 to 16 by applying a metallic sliding layer, in which particles of a metallic sliding material and oxygen are incorporated in a metallic matrix, to a metallic backing or guide by means of cathode sputtering, characterised in that during the cathode sputtering the backing or guide is kept at a temperature which is substantially lower than 0.5 $T_s$, $T_s$ being the absolute melting temperature of the matrix base metal.

18. Process according to Claim 17, characterised in that the coating speed is greater than 0.2 $\mu$m/min.

19. Process according to Claims 17 and 18, characterised in that the oxygen to be incorporated into the sliding layer is fed to the plasma gas in gaseous form as elemental oxygen, air, or as an oxygen compound of one or more of the elements hydrogen, carbon and nitrogen.

20. Process according to Claims 17 to 19, characterised in that argon is used as the plasma gas and a partial pressure of the gas supplying the oxygen of 1 to 50% of the total pressure is maintained during the cathode sputtering in a vacuum.

**21.** Process according to Claims 17 and 18, characterised in that the oxygen to be incorporated into the sliding layer is incorporated as an oxide into the target which is used in the cathode sputtering and which contains the matrix and the particles.

**22.** Process according to Claims 17 to 21, characterised in that the constituents forming the sliding layer are applied simultaneously to the backing or guide.

**23.** Process according to Claim 22, characterised in that at least 50% of the target used consists of the constituents forming the sliding layer.

**24.** Process according to Claims 17 to 21, characterised in that the constituents forming the sliding layer are applied consecutively to the backing or guide.

**25.** Process according to Claims 17 to 24, characterised in that the intermediate layer arranged between the sliding layer and the backing or guide is applied using the same target as for the sliding layer.

**26.** Process according to Claims 17 to 25, characterised in that the matrix is applied to the backing or guide at a higher temperature than the particles incorporated in the matrix.

**27.** Use of the sliding bearing according to Claims 1 to 16 for sliding bearing types and sliding bearing components according to DIN ISO 4378.

**Revendications**

**1.** Portée lisse constituée d'au moins une couche métallique de glissement, déposée par pulvérisation cathodique sur une pièce métallique de support ou de guidage, dans laquelle des particules d'un matériau métallique de glissement et de l'oxygène sont insérés dans une matrice métallique, caractérisée en ce que les particules ayant un diamètre de valeur moyenne de $x < 0,8$ micron et insérées selon une répartition statistique, sont en un matériau de glissement qui possède de meilleures propriétés de glissement que la matrice et la teneur en oxygène est comprise entre 0,5 et 2,0 % en poids, avec la condition que la teneur en oxygène augmente au fur et à mesure que diminue le diamètre des particules.

**2.** Portée lisse suivant la revendication 1, caractérisée en ce que le diamètre des particules se présentant sous une répartition statistique normale possède une valeur moyenne de $\overline{x} = 0,05$ à 0,4 micron.

**3.** Portée lisse suivant l'une des revendications 1 ou 2, caractérisée en ce que la matrice est en un matériau de glissement à base d'aluminium, de cuivre ou de fer.

**4.** Portée lisse suivant l'une des revendications 1 ou 3, caractérisée en ce que les particules sont en étain, en plomb, en bismuth, en cuivre et en zinc et sont insérées individuellement ou à plusieurs dans la matrice.

**5.** Portée lisse suivant l'une des revendications 1 à 4, caractérisée en ce que la couche métallique de glissementest constituée en un alliage du type AlSn5Cu, AlSn10Cu, AlSn20Cu, AlSn30Cu, AlSn40Cu, AlSn10Pb10Cu ou AlZn5Pb.

**6.** Portée lisse suivant l'une des revendications 1 à 5, caractérisée en ce que la couche de glissement a une épaisseur de 5 à 500 microns et, de préférence, de 10 à 20 microns.

**7.** Portée lisse suivant l'une des revendications 1 à 6, caractérisée en ce que plusieurs couches de glissement sont superposées à la manière d'un stratifié.

**8.** Portée lisse suivant la revendication 7, caractérisée en ce que la couche de glissement stratifiée a une épaisseur de 50 à 500 microns et, de préférence, de 50 à 150 microns.

**9.** Portée lisse suivant la revendication 7 ou 8, caractérisée en ce que les couches de glissement superposées de manière stratifiée ont des épaisseurs différentes.

10. Portée lisse suivant l'une des revendications 7 à 9, caractérisée en ce que les différentes couches de glissement superposées de manière stratifiée sont en matériaux de glissement différents et possèdent, le cas échéant, des teneurs en oxygène et/ou des diamètres de particules qui sont différents.

11. Portée lisse selon la revendication 10, caractérisée en ce que la composition des différentes couches de glissement superposées de manière stratifiée se transforme de manière continue en la composition des couches de glissement voisines.

12. Portée lisse suivant l'une des revendications 1 à 11, caractérisée en ce qu'une couche intermédiaire en nickel, en aluminium ou en leurs alliages, de préférence en NiCu, est interposée entre la couche de glissement et la pièce de support ou de guidage.

13. Portée lisse suivant la revendication 12, caractérisée en ce que la couche intermédiaire a une épaisseur de 1 à 5 microns et, de préférence, de 1,5 à 2,5 microns.

14. Portée lisse suivant la revendication 12 ou 13, caractérisée en ce que la composition de la couche de glissement et de la couche intermédiaire se transforme de manière continue de l'une à l'autre.

15. Portée lisse suivant l'une ou plusieurs des revendications 1 à 14, caractérisée en ce que la pièce de support ou de guidage portant la couche de glissement est constituée d'une couche d'acier.

16. Portée lisse suivant l'une ou plusieurs des revendications 1 à 14, caractérisée en ce que la pièce de support ou de guidage portant la couche de glissement est constituée d'une couche d'acier sur laquelle se trouve une couche support en un matériau composite formé d'un alliage de cuivre, d'aluminium ou de fer.

17. Procédé de fabrication d'une portée lisse suivant l'une des revendications 1 à 16 par dépôt d'une couche métallique de glissement, dans laquelle des particules d'un matériau métallique de glissement et de l'oxygène sont insérés dans une matrice métallique sur une pièce métallique de support ou de guidage au moyen d'une pulvérisation cathodique, caractérisé en ce qu'il consiste à maintenir la pièce de support ou de guidage, pendant la pulvérisation cathodique, à une température qui est sensiblement inférieure à 0,5 $T_s$, $T_s$ étant le point de fusion absolu du métal de base de la matrice.

18. Procédé suivant la revendication 17, caractérisé en ce que la vitesse de revêtement est supérieure à 0,2 micron à la minute.

19. Procédé suivant la revendication 17 ou 18, caractérisé en ce qu'il consiste à envoyer l'oxygène à insérer dans la couche de glissement au gaz de plasma sous forme gazeuse, en tant qu'oxygène élémentaire, qu'air ou que composé oxygéné d'un ou de plusieurs des éléments que sont l'hydrogène, le carbone et l'azote.

20. Procédé suivant l'une des revendications 17 à 19, caractérisé en ce qu'il consiste à utiliser, comme gaz de plasma, l'argon et à maintenir pendant la pulvérisation cathodique sous vide, une pression partielle du gaz fournissant l'oxygène représentant de 1 à 50 % de la pression totale.

21. Procédé suivant la revendication 17 ou 18, caractérisé en ce qu'il consiste à insérer l'oxygène à insérer dans la couche de glissement sous forme d'oxyde dans la cible utilisée pour la pulvérisation cathodique et contenant la matrice et les particules.

22. Procédé suivant l'une des revendications 17 à 21, caractérisé en ce qu'il consiste à déposer les constituants formant la couche de glissement simultanément sur la pièce de support ou de guidage.

23. Procédé suivant la revendication 22, caractérisé en ce qu'au moins 50 % de la cible utilisée est constituée des constituants formant la couche de glissement.

24. Procédé suivant l'une des revendications 17 à 21, caractérisé en ce qu'il consiste à déposer les constituants formant la couche de glissement successivement dans le temps sur la pièce de support ou de guidage.

25. Procédé suivant l'une des revendications 17 à 24, caractérisé en ce qu'il consiste à déposer la couche intermédiaire interposée entre la couche de glissement et la pièce de support ou de guidage, en utilisant la même cible que pour la couche de glissement.

26. Procédé suivant l'une des revendications 17 à 25, caractérisé en ce qu'il consiste à déposer la matrice sur la pièce de support ou de guidage à une température plus élevée que les particules insérées dans la matrice.

27. Utilisation de la portée lisse suivant les revendications 1 à 16 pour des types de paliers lisses et des éléments de paliers lisses suivant la norme DIN ISO4378.